## Europäisches Patentamt

(19) **European Patent Office**

**Office européen des brevets**

(11) Veröffentlichungsnummer: **0 133 216**
**B1**

(12) **EUROPÄISCHE PATENTSCHRIFT**

(45) Veröffentlichungstag der Patentschrift:
**01.04.87**

(51) Int. Cl.⁴: **G 03 F 7/08**

(21) Anmeldenummer: **84107697.9**

(22) Anmeldetag: **03.07.84**

(54) Verfahren zur Herstellung negativer Kopien mittels eines Materials auf Basis von 1,2-Chinondiaziden.

(30) Priorität: **11.07.83 DE 3325022**

(43) Veröffentlichungstag der Anmeldung:
**20.02.85 Patentblatt 85/8**

(45) Bekanntmachung des Hinweises auf die Patenterteilung:
**01.04.87 Patentblatt 87/14**

(84) Benannte Vertragsstaaten:
**AT BE CH DE FR GB IT LI NL SE**

(56) Entgegenhaltungen:
**Keine Entgegenhaltungen**

(73) Patentinhaber: **HOECHST AKTIENGESELLSCHAFT,
Postfach 80 03 20, D-6230 Frankfurt am Main 80 (DE)**

(72) Erfinder: **Stahlhofen, Paul, Dr., Leibnizstrasse 18b,
D-6200 Wiesbaden (DE)**

**Beschreibung**

Die Erfindung betrifft ein Umkehrverfahren zur Herstellung negativer Kopien mittels eines normalerweise positiv arbeitenden lichtempfindlichen Materials auf Basis von 1,2-Chinondiaziden.

Es ist bekannt, auf Basis von 1,2-Naphthochinondiaziden beruhende positiv arbeitende Reproduktionsmaterialien durch eine bestimmte Folge von Behandlungsschritten negativ zu verarbeiten. In der US-A-3 264 104 ist ein derartiges Umkehrverfahren beschrieben, bei dem die lichtempfindliche Schicht, die bevorzugt thermoplastische Polymere enthält, bildmässig belichtet, mit einer alkalischen Lösung oder mit Wasser, gegebenenfalls bei erhöhter Temperatur, behandelt wird, ohne die belichteten Stellen auszuwaschen, nochmals ohne Vorlage belichtet und dann wie üblich entwickelt wird, wobei die ursprünglich bildmässig belichteten Stellen stehenbleiben und die übrigen Stellen ausgewaschen werden.

Dieses Verfahren hat den Nachteil, dass es eine verhältnismässig grosse Zahl von Behandlungsschritten erfordert, dass die erste Alkalibehandlung stets mit besonderer Sorgfalt erfolgen muss, um möglichst wenig von der in wässrigem Alkali löslichen belichteten Schicht abzulösen, und dass es den Zusatz von in Alkali schwerlöslichen Polymeren erfordert, die die Verwendbarkeit des Materials für andere Zwecke einschränken.

Aus der EP-A-24 916 ist für die Herstellung von Resistschichten ein ähnliches Umkehrverfahren bekannt, bei dem ein Material auf Basis von 1,2-Chinondiaziden nach bildmässiger Belichtung erhitzt, dann ohne Vorlage nachbelichtet und mit wässrigem Alkali zum Negativ entwickelt wird. Das Material enthält in der lichtempfindlichen Schicht bestimmte photochrome Verbindungen, die beim Erwärmen mit den Lichtreaktionsprodukten des Chinondiazids reagieren und zu einer Schichthärtung führen sollen. Dieses Material ist an die Anwesenheit von photochromen Substanzen gebunden, deren Lichtreaktion eine bei manchen Anwendungen störende Verfärbung ergibt.

In der GB-A-2 082 339 wird ein lichtempfindliches Gemisch, bestehend aus einem o-Chinondiazid und mindestens einem Resol, für die Herstellung einer lithografischen Druckplatte beschrieben, die ebenfalls sowohl positiv als auch negativ verarbeitet werden kann. Dieses Umkehrverfahren enthält die gleiche Folge von Schritten wie das zuvor genannte. Seine Wirkung beruht darauf, dass die Lichtzersetzungsprodukte des o-Chinondiazids mit dem Resol in der Wärme ein unlösliches Reaktionsprodukt ergeben. Diese Reaktion tritt mit Novolaken nicht ein. Von Nachteil ist die relativ mangelhafte Lagerfähigkeit dieser Druckplatten infolge der Eigenhärtung von Resolen.

In den DE-A-2 855 723 und 2 529 054 werden Resistschichten auf Basis von 1,2-Chinondiaziden für ein Umkehrverfahren beschrieben, die als Zusatz zur thermischen Schichthärtung N-Acyl-N'-methylol-ethylendiamine oder Hydroxyethylimidazole enthalten. Ein ähnliches Material mit einem Gehalt an sekundären oder tertiären Aminen wird in der US-A-4 196 003 beschrieben.

Derartige Zusätze haben jedoch im allgemeinen einen nachteiligen Einfluss auf die Lagerfähigkeit der Kopierschichten und auf bestimmte kopiertechnische Eigenschaften, z.B. die Lichtempfindlichkeit und den Bildkontrast nach dem Belichten. Auch ist für viele Anwendungszwecke die zur Bildumkehr erforderliche Temperatur zu hoch oder die Dauer des Erhitzens bei niedrigerer Temperatur ist zu lang.

Aufgabe der Erfindung war es, ein Umkehrverfahren zur Herstellung negativer Kopien mittels eines normalerweise positiv arbeitenden lichtempfindlichen Materials auf Basis von 1,2-Chinondiaziden vorzuschlagen, das keine Zusätze zur Kopierschicht erfordert, die deren Lagerfähigkeit beeinträchtigen, und das nur kurzzeitiges Erwärmen auf relativ niedrige Temperaturen erfordert, um eine thermische Härtung der belichteten Schichtbereiche zu ermöglichen.

Gegenstand der Erfindung ist ein Verfahren zur Herstellung von negativen Reliefkopien, bei dem ein lichtempfindliches Material aus einem Schichtträger und einer lichtempfindlichen Schicht, die als wesentliche Bestandteile eine die thermische Härtung fördernde Verbindung und ein 1,2-Chinondiazid enthält, bildmässig belichtet, danach erwärmt, nach dem Abkühlen nochmals ohne Vorlage belichtet und dann mittels eines wässrig-alkalischen Entwicklers entwickelt wird.

Das erfindungsgemässe Verfahren ist dadurch gekennzeichnet, dass das Material als die thermische Härtung fördernde Verbindung einen Ether des Hexamethylolmelamins enthält.

Brauchbare Sensibilisatoren, die gemäss der Erfindung verwendet werden können, sind alle 1,2-Chinondiazid-sulfonsäureester, 1,2-Chinondiazid-sulfonsäureamide, 1,2-Chinondiazid-carbonsäureester und -amide, die nach dem Bestrahlen mit aktinischem Licht in wässrig-alkalischen Lösungen löslich werden. Hierzu zählen die Umsetzungsprodukte von 1,2-Benzo- oder 1,2-Naphthochinon-diazid-4- oder -5-sulfonsäure bzw. von deren Säurechloriden mit Phenol-Aldehyd/Aceton-Kondensationsprodukten oder Polymeren aus p-Hydroxystyrol, p-Aminostyrol oder Copolymeren dieser beiden Verbindungen.

Die Amide und Ester der 1,2-Chinondiazid-4-sulfonsäuren und der -4-carbonsäuren werden mit besonderem Vorteil verwendet, da sie bereits ohne Zusatz von Hexamethylolmelaminethern bei der beschriebenen Verarbeitung eine Umkehrwirkung ergeben. Bei Einsatz dieser Verbindungen ist es deshalb möglich, entweder die Menge an Hexamethylolmelaminether oder die Dauer oder die Temperatur des Erhitzens herabzusetzen.

Als Ester der 1,2-Chinondiazidderivate kommen die bekannten Umsetzungsprodukte der Säuren oder ihrer Halogenide mit Phenolen, insbesondere mehrwertigen Phenolen in Betracht, z.B. mit 2,3,4-Trihydroxy-benzophenon, 2,4-Dihydroxy-benzophenon, 4-Decanoyl-resorcin, 4-(2-Phenyl-prop-2-yl)-phenol, Gallaussäureoctylester, oder 4,4-Bis-(4-hydroxyphenyl)valeriansäurebutylester. Die Amide können in bekannter Weise von längerkettigen aliphatischen oder bevorzugt aromatischen Aminen abgeleitet sein.

Die Menge an o-Chinondiazidverbindungen beträgt im allgemeinen 3 bis 50, bevorzugt 7 bis 35 Gew.-%, bezogen auf die nichtflüchtigen Anteile der Kopierschicht.

Die Alkylethergruppen der Hexamethylolmelaminether haben im allgemeinen 1-10, vorzugsweise 1-4 Kohlenstoffatome. Die Methylether werden bevorzugt. Das Hexamethylolmelamin kann vollständig oder teilweise verethert sein. Als teilweise veretherte Produkte kommen insbesondere technische Gemische von Komponenten mit unterschiedlichem Veretherungsgrad in Betracht. Im allgemeinen wird den Hexaalkylethern vor den partiel veretherten Verbindungen der Vorzug gegeben. Die Konzentration der Hexamethylolmelaminether in dem lichtempfindlichen Gemisch kann in relativ weiten Grenzen schwanken. Im allgemeinen liegt der Anteil bei 1-50, vorzugsweise zwischen 3 und 45 Gew.-%, bezogen auf das Gewicht der nicht-flüchtigen Bestandteile des lichtempfindlichen Gemisches. Wenn das Gemisch ein polymeres Bindemittel enthält, liegt der Mengenanteil des Hexamethylolmelamins bevorzugt nicht über 30 Gew.-%.

Die Reaktionsfähigkeit der vernetzenden Gruppen -CH$_2$-O-R der Hexamethylolmelaminether reicht bei normaler Umgebungstemperatur offenbar nicht zu einer vorzeitigen Vernetzung in der Schicht aus, so dass die im unbelichteten Zustand bei Raumtemperatur gelagerten Kopierschichten eine hohe Lagerfähigkeit aufweisen.

Die lichtempfindlichen Gemische enthalten ferner vorzugsweise ein polymeres, wasserunlösliches harzzartiges Bindemittel, das sich in den für das erfindungsgemässe Gemisch verwendeten Lösungsmitteln löst und in wässrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Bindemittel auch bei dem erfindungsgemässen Verfahren als vorteilhaft erwiesen. Die Novolake können auch in bekannter Weise durch Umsetzung eines Teils ihrer Hydroxygruppen, z.B. mit Chloressigsäure, Isocyanaten, Epoxiden oder Carbonsäureanhydriden, modifiziert sein. Als weitere alkalilösliche bzw. in Alkali quellbare Bindemittel werden Polyhydroxyphenylharze, die durch Kondensation aus Phenolen und Aldehyden oder Ketonen hergestellt werden, Mischpolymerisate aus Styrol und Maleinsäureanhydrid, Polyvinylphenole, oder Mischpolymerisate der Acrylsäure oder Methacrylsäure, insbesondere mit Acryl- oder Methacrylsäureestern, bevorzugt. Die Art und Menge des alkalilöslichen Harzes kann je nach Anwendungszweck verschieden sein; bevorzugt werden Anteile am Gesamtfeststoff zwischen 90 und 30, besonders bevorzugt 85-55 Gew.-%.

Zusätzlich können noch zahlreiche andere Harze mitverwendet werden, bevorzugt Epoxyharze und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren sowie hydrierte oder teilhydrierte Kolophoniumderivate. Der günstigste Anteil an diesen Harzen richtet sich nach den anwendungstechnischen Erfordernissen und dem Einfluss auf die Entwicklungsbedingungen und beträgt im allgemeinen nicht mehr als 50 Gew.-%, bevorzugt etwa 2 bis 35 Gew.-%, vom alkalilöslichen Harz. In geringen Mengen kann das lichtempfindliche Gemisch für spezielle Erfordernisse wie Flexibilität, Haftung, Glanz und Färbung, ausserdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Ferner können dem lichtempfindlichen Gemisch für den Farbumschlag nach dem Belichten noch geringe Mengen von strahlungsempfindlichen Komponenten beigefügt werden, die beim Belichten vorzugsweise starke Säuren bilden bzw. abspalten und in einer Folgereaktion mit einem geeigneten Farbstoff einen Farbumschlag hervorrufen. Derartige strahlungsempfindliche Komponenten sind zum Beispiel 1,2-Naphtochinondiazid-4-sulfonsäurechlorid, chromophor substituierte Halogenmethyl-s-triazine oder Diazoniumverbindungen in Form ihrer Salze mit komplexen Säuren wie Borfluorwasserstoffsäure oder Hexafluorwasserstoffsäure.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemässe Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether, werden besonders bevorzugt.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z.B. mit Polyvinylphosphonsäure, Silikaten, Phosphaten, Hexafluorozirkonaten oder mit hydrolysierten Tetraethylorthosilikat, vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Giesser-Antrag. Belichtet wird mit den in der Technik üblichen Lichtquellen. Auch das Bestrahlen mit Elektronen oder Lasern stellt eine Möglichkeit zur Bebilderung dar.

Zum Entwickeln werden wässrig-alkalische Lösungen abgestufter Alkalität verwendet, vorzugsweise mit einem pH im Bereich von 10-14, die auch kleinere Mengen organischer Lösungs- oder Netzmittel enthalten können.

Nach dem bildmässigen Bestrahlen bzw. Belichten wird das Material ohne weitere Zwischenbehandlung erwärmt. Das Erwärmen kann durch Bestrahlung, Konvektion, durch Kontakt mit erwärmten Flächen, z.B. Walzen, oder durch Tauchen in ein erwärmtes Bad einer inerten Flüssigkeit, z.B. Wasser, erfolgen. Die Temperatur kann zwischen 70 und 150, vorzugsweise bei 90 bis 130°C liegen. Derartige Temperaturen werden von den Gemischen vertragen, ohne dass die Eigenschaften der unbelichteten Bereiche wesentlich verändert werden. Die Dauer des Erwärmens kann je nach Art der Wärmeeinwirkung sehr unterschiedlich sein. Bei Übertragung durch ein Wärmemedium liegt sie im allgemeinen zwischen 10 Sekunden und 10 Minuten, vorzugsweise zwischen 30 Sekunden und 4 Minuten.

Nach dem Erwärmen und Abkühlen wird die lichtempfindliche Schicht einer Totalbelichtung unterworfen, um die noch lichtempfindlichen Schichtbereiche vollständig in ihre Lichtzersetzungsprodukte umzuwandeln. Die Nachbelichtung kann vorteilhaft unter der gleichen Lichtquelle erfolgen, die zur Bildbelichtung verwendet wurde.

An die Nachbelichtung schliesst sich eine Entwicklung mit üblichen Entwicklern an, wobei die Schichtbereiche ausgewaschen werden, die bei der ursprünglichen Bildbelichtung nicht vom Licht getroffen waren. Als Entwickler sind vorzugsweise wässrige Lösungen von alkalischen Substanzen, z.B. von Alkaliphosphaten, -silikaten, -carbonaten oder -hydroxiden geeignet, die ferner Netzmittel oder kleinere Mengen organischer Lösungsmittel enthalten können. In bestimmten Fällen sind auch organische Lösungsmittel oder Gemische derselben mit Wasser als Entwickler geeignet. Die Entwicklung kann unmittelbar nach dem Erwärmen und Abkühlen oder auch in zeitlichem Abstand von z.B. mehreren Stunden erfolgen, ohne dass die gehärteten Schichtbereiche angegriffen werden. Daraus ist zu schliessen, dass die Schichthärtung der belichteten Stellen durch Erwärmen irreversibel ist.

Das erfindungsgemässe Verfahren hat den Vorteil gegenüber den bekannten Umkehrverfahren, dass trotz guter Lagerfähigkeit der Kopierschichten die Aushärtung der bildmässig belichteten Schichtbereiche bei erhöhter Temperatur relativ schnell erfolgt und dass die Temperatur des für den Umkehrschritt erforderlichen Temperns niedriger und die Verweilzeit bei erhöhter Temperatur wesentlich kürzer ist als bei den bekannten Verfahren.

Das Verfahren ermöglicht es ferner, durch Variation der Belichtungszeiten die Auflösung zu steuern.

Zusätzliche Behandlungsschritte mit Flüssigkeiten oder eine besondere Zusammensetzung des lichtempfindlichen Materials sind nicht erforderlich. Der einzige zusätzliche Behandlungsschritt, das Erwärmen, kann zumeist mit vorhandenen Trocknungsgeräten bequem durchgeführt werden. Die Nachbelichtung ohne Vorlage wird am einfachsten wieder mit der Kopierlichtquelle durchgeführt.
Das erfindungsgemässe Verfahren kann z.B. zur Herstellung von Druckformen für den Hoch-, Tief- und Flachdruck sowie von Photoresistschablonen für die subtraktiver und additive Leiterplattenherstellung, für die galvanische Herstellung von Nickelrotationszylindern oder für die Maskenherstellung in der Mikroelektronik nach der Liftoff-Technik eingesetzt werden.

Die folgenden Beispiele beschreiben bevorzugte Ausführungsformen des erfindungsgemässen Verfahrens. Prozentzahlen und Mengenverhältnisse sind, wenn nichts anderes angegeben ist, in Gewichtseinheiten zu verstehen.

*Beispiel 1*
Mit einer Lösung von

3,00 Gt des Veresterungsproduktes aus 1 mol 4-(2-Phenyl-prop-2-yl)phenol und 1 mol Naphthochinon-(1,2)-diazid-(2)-4-sulfonsäurechlorid,

0,20 Gt Naphthochinon-(1,2)-diazid-(2)-4-sulfonsäurechlorid,

6,00 Gt eines Kresol-Formaldehyd-Novolaks mit einem Erweichungspunkt von 105-120°C nach Kapillar-Methode DIN 53 181 und

2,00 Gt Hexamethylolmelamin-hexamethylether

0,06 Gt Kristallviolett in

50,00 Gt Ethylenglykolmonomethylether und

50,00 Gt Tetrahydrofuran

wurde eine elektrolytisch aufgerauhte und anodisierte Aluminiumplatte beschichtet. Der anodisierte Aluminiumträger war vor dem Aufbringen der lichtempfindlichen Kopierschicht mit einer wässrigen Lösung von Polyvinylphosphonsäure behandelt worden, wie es in der DE-C-1 621 478 beschrieben ist.

Das so hergestellte vorsensibilisierte Material mit einem Schichtgewicht von ca. 2,9 g/m² wurde unter einer transparenten Positiv-Vorlage bildmässig belichtet und anschliessend mit einer 2%igen wässrigen Lösung von Natriummetasilikat × 9 Wasser entwickelt. Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Druckschablone erhielt. Durch Einfärben mit Fettfarbe wurde eine druckfertige Positiv-Druckform erhalten.

Eine andere Probe des gleichen vorsensibilisierten Materials wurde als Negativ-Druckplatte verarbeitet. Zu diesem Zweck wurde die Probe unter einer negativen Vorlage belichtet, anschliessend 30 Sekunden auf 90°C oder 2 Minuten auf 80°C erwärmt und dann ohne Vorlage dieselbe Zeit wie bei der bildmässigen Belichtung nachbelichtet. Beim Entwickeln im gleichen Entwickler innerhalb der gleichen Zeit entstand das Umkehrbild der Vorlage.

Sowohl die Positiv-Druckform als auch die Negativ-Druckform lässt sich bei Temperaturen oberhalb 180°C einbrennen, wodurch die Auflagenleistung um ein Mehrfaches gesteuert werden kann.

*Beispiel 2*
Mit einer Lösung von

4,00 Gt des Veresterungsproduktes aus 1 mol 2,3,4-Trihydroxy-benzophenon und 3 mol Naphthochinon-1,2-diazid-(2)-5-sulfonsäurechlorid,

3,00 Gt   Hexamethylolmelamin-hexamethylester,

0,30 Gt   Naphthochinon-(1,2)-diazid-(2)-4-sul-
fonsäurechlorid und

0,06 Gt   Kristallviolett in

25,00 Gt   Ethylenglykolmonomethylether und

25,00 Gt   Tetrahydrofuran

wurde eine elektrochemisch aufgerauhte und anodisierte Aluminiumplatte beschichtet, die mit einer wässrigen Lösung von 0,1 Gew.-% Polyvinylphosphonsäure behandelt worden war.

Das so hergestellte vorsensibilisierte Material mit einem Schichtgewicht von 3 g/m$^2$ wurde unter einer transparenten Positiv-Vorlage bildmässig belichtet und anschliessend mit einer 0,5%igen Natriummetasilikat-Lösung entwickelt, wodurch eine der Vorlage entsprechende positive Druckschablone erhalten wurde.

Eine andere Probe des gleichen Materials wurde als Negativ-Druckplatte verarbeitet, indem unter einer negativen Vorlage belichtet, anschliessend 30 Sekunden auf 120°C oder 1 Minute auf 100°C oder 3 Minuten auf 90°C oder 4 Minuten auf 80°C erwärmt und ohne Vorlage dieselbe Zeit wie bei der bildmässigen Belichtung nachbelichtet wurde. beim Entwickeln im gleichen Entwickler innerhalb der gleichen Zeit entstand das Umkehrbild der Vorlage.

*Beispiel 3*
Mit einer Lösung von

3,00 Gt   des in Beispiel 2 angegebenen Naphthochinondiazidsulfonsäureesters,

6,00 Gt   des in Beispiel 1 angegebenen Kresol-
Formaldehyd-Novolaks,

3,00 Gt   Hexamethylolmelamin-hexamethylether,

0,30 Gt   2-(4-Ethoxy-naphth-1-yl)-4,6-bis-tri-
chlormethyl-s-triazin und

0,06 Gt   Kristallviolett in

50,00 Gt   Ethylenglykolmonomethylether und

50,00 Gt   Tetrahydrofuran

wurde eine wie in Beispiel 1 behandelte Aluminiumplatte beschichtet.

Das so hergestellte vorsensibilisierte Material mit einem Schichtgewicht von 3,0 g/m$^2$ wurde unter einer transparenten Positiv-Vorlage bildmässig belichtet und anschliessend mit einer 4%igen Natriummetasilikatlösung entwickelt, wodurch eine der Vorlage entsprechende positive Druckschablone erhalten wurde.

Eine andere Probe des gleichen Materials wurde als Negativ-Druckplatte verarbeitet, indem sie unter einer negativen Vorlage belichtet , anschliessend 30 Sekunden auf 120°C oder 1 Minute auf 100°C oder 2 Minuten auf 90°C oder 4 Minuten auf 80°C erwärmt und ohne Vorlage dieselbe Zeit wie bei der bildmässigen Belichtung nachbelichtet wurde. Beim Entwickeln im gleichen Entwickler innerhalb der gleichen Zeit entstand das Umkehrbild der Vorlage.

*Beispiel 4*
Mit einer Lösung von

4,00 Gt   des Veresterungsprodukts aus 1 mol des
Ethoxyethylesters der 4,4-Bis-(4-Hy-
droxyphenyl)-n-valeriansäure und 2 mol
Naphthochinon-(1,2)-diazid-(2)-5-sul-
fonsäurechlorid,

5,00 Gt   eines Poly-p-vinylphenols mit einem
mittleren Molgewicht von 10000,

1,00 Gt   Hexamethylolmelamin-hexamethylether,

0,20 Gt   Naphthochinon-(1,2)-diazid-(2)-4-sul-
fonsäurechlorid und

0,07 Gt   Kristallviolett in

50,00 Gt   Ethylenglykolmonomethylether und

50,00 Gt   Tetrahydrofutan

wurde eine wie in Beispiel 1 vorbehandelte Aluminiumplatte beschichtet. Das so hergestellte vorsensibilisierte Material mit einem Schichtgewicht von 2,8 g/m$^2$ wurde unter einer transparenten Positiv-Vorlage bildmässig belichtet und anschliessend mit einer 1%igen Natriummetasilikat-Lösung entwickelt, wodurch eine der Vorlage entsprechende positive Druckschablone erhalten wurde.

Eine andere Probe des gleichen Materials wurde als Negativ-Druckplatte verarbeitet, indem sie unter einer negativen Vorlage belichtet, anschliessend 30 Sekunden auf 140°C oder 2 Minuten auf 100°C oder 3 Minuten auf 90°C erwärmt und ohne eine Vorlage dieselbe Zeit wie bei der bildmässigen Belichtung nachbelichtet wurde. Beim Entwickeln im gleichen Entwickler innerhalb der gleichen Zeit entstand das Umkehrbild der Vorlage.

*Beispiel 5*
Mit einer Lösung von

3,00   Gt   des in Beispiel 1 angegebenen Naphthochinondiazidsulfonsäureesters,

6,00   Gt   des in Beispiel 1 angegebenen Kresol-
Formaldehyd-Novolaks,

0,60   Gt   Hexamethylolmelamin-hexamethylether,

0,10   Gt   2-(4-Ethoxy-naphth-1-yl)-4,6-bis-tri-
chlormethyl-s-triazin und

0,075 Gt   Kristallviolett in

50,00   Gt   Ethylenglykolmonomethylether und
50,00   Gt   Tetrahydrofuran

wurde eine elektrolytisch aufgerauhte und anodisierte Aluminiumplatte beschichtet.

Das so hergestellte vorsensibilisierte Material mit einem Schichtgewicht von 2,5 g/m$^2$ wurde unter einer transparenten Positiv-Vorlage bildmässig belichtet und anschliessend mit einer 2%igen Natriummetasilikatlösung entwickelt, wodurch eine der Vorlage entsprechende positive Druckschablone erhalten wurde.

Eine andere Probe des gleichen Materials wurde als Negativ-Druckplatte verarbeitet, indem sie unter einer negativen Vorlage belichtet, anschliessend 30 Sekunden auf 120°C oder 1 Minute auf 100°C erwärmt und ohne eine Vorlage dieselbe Zeit wie bei der bildmässigen Belichtung nachbelichtet wurde. Beim Entwickeln im gleichen Entwickler innerhalb der gleichen Zeit entstand das Umkehrbild der Vorlage.

**Patentansprüche**

1. Verfahren zur Herstellung von negativen Reliefkopien, bei dem ein lichtempfindliches Material aus einem Schichtträger und einer lichtempfindlichen Schicht, die als wesentliche Bestandteile eine die thermische Härtung fördernde Verbindung und ein 1,2-Chinondiazid enthält, bildmässig belichtet, danach erwärmt, nach dem Abkühlen nochmals ohne Vorlage belichtet und dann mittels eines wässrig-alkalischen Entwicklers entwickelt wird, dadurch gekennzeichnet, dass das Material als die thermische Härtung fördernde Verbindung einen Ether des Hexamethylolmelamins enthält.

2. Verfahren nach Anspruch 1, dadurch gekennzeichnet, dass die die thermische Härtung fördernde Verbindung Hexamethylolmelaminhexamethylether ist.

3. Verfahren nach Anspruch 1, dadurch gekennzeichnet, dass man das bildmässig belichtete Material auf eine Temperatur im Bereich von 70-150°C erwärmt.

4. Verfahren nach Anspruch 1 oder 2, dadurch gekennzeichnet, dass man das Material 10 Sekunden bis 10 Minuten erwärmt.

5. Verfahren nach Anspruch 1, dadurch gekennzeichnet, dass das Material ein wasserunlösliches, in wässrig-alkalischen Lösungen lösliches Bindemittel enthält.

6. Verfahren nach Anspruch 5, dadurch gekennzeichnet, dass das Bindemittel ein Novolak ist.

7. Verfahren nach Anspruch 1, dadurch gekennzeichnet, dass die lichtempfindliche Schicht 3 bis 50 Gew.-% an 1,2-Chinondiazidverbindungen, bezogen auf ihre nichtflüchtigen Bestandteile, enthält.

8. Verfahren nach Anspruch 1, dadurch gekennzeichnet, dass die lichtempfindliche Schicht 1 bis 50 Gew.-% Hexamethylolmelaminether, bezogen auf ihre nicht-flüchtigen Bestandteile, enthält.

9. Verfahren nach Anspruch 1, dadurch gekennzeichnet, dass die lichtempfindliche Schicht als 1,2-Chinondiazid einen Ester oder ein Amid einer 1,2-Chinondiazid-4-sulfonsäure oder -4-carbonsäure enthält.

**Claims**

1. Process for producing negative relief copies, by imagewise exposing a light-sensitive material comprising a support and a light-sensitive layer which comprises as the essential constituents a compound which promotes thermal curing and a 1,2-quinone diazide, thereafter heating the material and, after cooling, exposing the material again without an original and then developing it by means of an aqueous-alkaline developer, wherein the material comprises, as a compound which promotes thermal curing, an ether of hexamethylol melamine.

2. A process as claimed in claim 1, wherein the compound which promotes thermal curing comprises hexamethylol melamine hexamethyl ether.

3. A process as claimed in claim 1, wherein the material which has been exposed imagewise is heated to a temperature in the range from 70 to 150°C.

4. A process as claimed in claim 1 or claim 2, wherein the material is heated for a period of time ranging from 10 seconds to 10 minutes.

5. A process as claimed in claim 1, wherein the material comprises a binder which is insoluble in water and soluble in aqueous-alkaline solutions.

6. A process as claimed in claim 5, wherein the binder used comprises a novolak.

7. A process as claimed in claim 1, wherein the light-sensitive layer comprises from 3 to 50% by weight of 1,2-quinone diazide compounds, based on its non-volatile constituents.

8. A process as claimed in claim 1, wherein the light-sensitive layer comprises from 1 to 50% by weight of hexamethylol melamine ether, based on its non-volatile constituents.

9. A process as claimed in claim 1, wherein the light-sensitive layer comprises, as the 1,2-quinone diazide, an ester or an amide of a 1,2-quinone-diazide-4-sulfonic acid or of a 1,2-quinone-diazide-4-carboxylic acid.

**Revendications**

1. Procédé de production de copies en relief négatives, dans lequel on expose suivant une image un matériau photosensible constitué d'un support et d'une couche photosensible, qui contient comme constituants essentiels un composé favorisant le durcissement thermique et un 1,2-quinonediazide, puis on le chauffe, on l'expose à nouveau sans original après le refroidissement, puis on le développe au moyen d'un développateur aqueux-alcalin, caractérisé en ce que le matériau contient, comme composé favorisant le durcissement thermique, un éther de l'hexaméthylolmelamine.

2. Procédé suivant la revendication 1, caractérisé en ce que le composé favorisant le durcissement thermique est un éther hexaméthylique de l'hexaméthylolmélamine.

3. Procédé suivant la revendication 1, caractérisé en ce que l'on chauffe le matériau exposé suivant une image à une température dans le domaine de 70 à 150°C.

4. Procédé suivant les revendications 1 ou 2, caractérisé en ce qu'on chauffe le matériau 10 secondes à 10 minutes.

5. Procédé suivant la revendication 1, caractérisé en ce que le matériau contient un liant insoluble dans l'eau, soluble dans les solutions aqueuses-alcalines.

6. Procédé suivant la revendication 5, caractérisé en ce que le liant est une novolaque.

7. Procédé suivant la revendication 1, caractérisé en ce que la couche photosensible contient 3 à 50% en poids de 1,2-quinonediazide, par rapport à ses constituants non volatils.

8. Procédé suivant la revendication 1, caractérisé en ce que la couche photosensible contient 1 à 50% en poids d'éther de l'hexaméthylolmélamine, par rapport à ses constituants non volatils.

9. Procédé suivant la revendication 1, caractérisé en ce que la couche photosensible contient, comme 1,2-quinonediazide, un ester ou un amide d'un acide 1,2-quinonediazide-4-sulfonique ou -4-carboxylique.